(19) Europäisches Patentamt
European Patent Office
Office européen des brevets

(11) **EP 2 137 499 B1**

(12) **EUROPÄISCHE PATENTSCHRIFT**

(45) Veröffentlichungstag und Bekanntmachung des Hinweises auf die Patenterteilung:
**15.03.2017 Patentblatt 2017/11**

(21) Anmeldenummer: **07856150.3**

(22) Anmeldetag: **21.12.2007**

(51) Int Cl.:
*G01D 5/20* (2006.01)       *G01D 5/22* (2006.01)
*G01B 7/00* (2006.01)       *H01H 36/00* (2006.01)
*H03K 17/95* (2006.01)

(86) Internationale Anmeldenummer:
**PCT/DE2007/002308**

(87) Internationale Veröffentlichungsnummer:
**WO 2008/074317 (26.06.2008 Gazette 2008/26)**

(54) **VERFAHREN UND SENSORANORDNUNG ZUM BESTIMMEN DER POSITION UND/ODER POSITIONSÄNDERUNG EINES MESSOBJEKTS RELATIV ZU EINEM SENSOR**

METHOD AND SENSOR ARRANGEMENT FOR DETERMINING THE POSITION AND/OR CHANGE OF POSITION OF A MEASURED OBJECT RELATIVE TO A SENSOR

PROCÉDÉ ET SYSTÈME DE DÉTECTEUR POUR LA DÉTERMINATION DE LA POSITION ET/OU DE LA MODIFICATION DE LA POSITION D'UN OBJET MESURÉ PAR RAPPORT À UN DÉTECTEUR

(84) Benannte Vertragsstaaten:
**AT BE BG CH CY CZ DE DK EE ES FI FR GB GR HU IE IS IT LI LT LU LV MC MT NL PL PT RO SE SI SK TR**

(30) Priorität: **21.12.2006 DE 102006061845**

(43) Veröffentlichungstag der Anmeldung:
**30.12.2009 Patentblatt 2009/53**

(73) Patentinhaber: **Micro-Epsilon Messtechnik GmbH & Co. KG**
**94496 Ortenburg (DE)**

(72) Erfinder: **MEDNIKOV, Vladislav**
**443096 Samara (RU)**

(74) Vertreter: **Patent- und Rechtsanwälte Ullrich & Naumann**
**PartG mbB**
**Schneidmuehlstrasse 21**
**69115 Heidelberg (DE)**

(56) Entgegenhaltungen:
EP-A- 1 158 266        DE-A5-112007 003 357
US-A1- 2002 163 328    US-B1- 6 605 939

**Beschreibung**

Die Erfindung betrifft ein Verfahren zum Bestimmen der Position und/oder Positionsänderung eines Messobjekts relativ zu einem Sensor, wobei der Sensor vorzugsweise eine mit Wechselstrom beaufschlagte Sensorspule aufweist. Des Weiteren betrifft die Erfindung eine entsprechende Sensoranordnung.

Elektromagnetische Sensoren finden in der Technik weite Verbreitung. Sie werden beispielsweise zum Überwachen des Abstands zwischen einem Sensor und einem Messobjekt, zur Messung von Dreh- oder Ventilhubbewegungen, zur Ermittlung der Position eines Kolbens oder zum Detektieren von leitfähigen Objekten eingesetzt. Diese nicht abschließende Aufzählung belegt die umfangreichen Einsatzmöglichkeiten dieser Sensorgattung.

Bei einem aus der DE 36 10 479 A1 bekannten Wegsensor wird als Messobjekt ein Dauermagnet verwendet, der längs eines weichmagnetischen Kerns bewegbar ist. Um den Kern herum sind zwei gegensinnig beaufschlagte Erregerspulen und eine Sekundärspule gewickelt. Abhängig von der Position des Messobjekts gegenüber dem Sensor wird an einer Stelle des weichmagnetischen Kerns ein virtueller Luftspalt erzeugt, der zur Folge hat, dass sich die in der Sekundärspule induzierte Spannung mit der Position des Messobjekts ändert. Die Spannung ist proportional zur Position des Messobjekts relativ zum Sensor.

Aus der EP 1 158 266 A1 ist ein Wegmesssystem bekannt, das einen induktiven Sensor, einen Geber und eine Auswerteeinheit umfasst. Gemäß einem Ausführungsbeispiel wird als Geber ein Magnet eingesetzt, dessen Position relativ zum Sensor variieren kann. Das Magnetfeld des Magneten bringt das weichmagnetische Material des Sensors in Sättigung. Durch diesen lokalen Sättigungseffekt verändert sich die Induktivität der Messspule des Sensors, die an einen Oszillator gekoppelt ist, dessen Frequenz- oder Amplitudenänderungen detektiert wird.

Aus der DE 203 07 652 U1 ist ein magnetisch betätigbarer Wegaufnehmer mit einem Magnetfeldsensor und einem entlang einer Bewegungslinie verlagerbaren Magneten bekannt. Parallel zur Bewegungslinie ist ein Stab aus weichmagnetischem Material angeordnet, von dessen Stirnseite der Magnetfeldsensor mit seiner Sensorrichtung auf die Stirnseite weisend angeordnet ist. Die Länge des Stabes und die Breite des Magneten bestimmen den Messbereich des Wegaufnehmers.

Für die berührungslose Erfassung einer Drehbewegung eines Polrades werden Sensoren mit magnetoelektrischen Wandlern verwendet. Beispiele hierfür sind aus der US 4 926 122 A, EP 0 729 589 B1 oder DE 30 41 041 C2 bekannt. In der Praxis werden diese Wandler sehr dicht an dem Messobjekt positioniert, um eine hohe Störfestigkeit zu gewährleisten. Bei diesen geringen Abständen (häufig in der Größenordnung von 1 mm) kann der Sensor, insbesondere unter realen Betriebsbedingungen, beschädigt werden. Es ist insbesondere im dynamischen Betrieb wichtig, eine sichere Erfassung der Drehbewegung bei relativ großem Grundabstand zu erreichen.

Weitere Sensoren und Näherungsschalter, die den Sättigungseffekt von weichmagnetischen Materialien hoher Permeabilität nutzen, sind aus der DE 38 03 293 A1 DE 38 03 253 A1, DE 36 10 479 A1, US 2002/0163328 A1 oder der US 6,605,939 B1 bekannt. Der Ansprechabstand derartiger Sensoren ist jedoch begrenzt. Um die größeren Messbereiche zu erreichen, muss die Auswerteschaltung einen hohen Verstärkungsfaktor aufweisen. Dies führt jedoch zu großen temperaturbedingten Fehlern und hohen Anforderungen an die Einbautolleranzen.

Der Erfindung liegt daher die Aufgabe zugrunde, ein Verfahren anzugeben, mit dem eine Position oder eine Positionsänderung eines Messobjekts relativ zu einem Sensor sowohl im statischen als auch im dynamischen Betrieb mit hoher Auflösung gemessen werden kann. Ferner soll eine entsprechende Vorrichtung mit möglichst einfacher Konstruktion angegeben werden.

Erfindungsgemäß wird die voranstehende Aufgabe durch die Merkmale des Patentanspruches 1 gelöst. Danach ist das erfindungsgemäße Verfahren dadurch gekennzeichnet, dass durch einen dem Messobjekt zugeordneten Magneten in einer weichmagnetischen Folie, deren Permeabilität sich unter Einfluss eines Magnetfelds in Abhängigkeit der Feldstärke des Magnetfelds ändert und die in dem Einflussbereich des Sensors angeordnet ist, eine Änderung der Permeabilität der Folie hervorgerufen wird, dass die Änderung der Permeabilität der Folie aus deren Rückwirkung auf den Sensor und daraus die Position und/oder Positionsänderung des Messobjekt relativ zu dem Sensor bestimmt wird und dass durch eine mit Gleichstrom erregte Kompensationsspule ein Magnetfeld erzeugt wird, mittels dessen die Permeabilität der Folie oder Teile der Folie beeinflusst wird. Der Bestimmung einer Position oder Positionsänderung gleichgestellt ist die Bestimmung eines Winkels, einer Winkeländerung oder einer Drehzahlmessung.

In vorrichtungsmäßiger Hinsicht wird die voranstehende Aufgabe durch die Merkmale des Patentanspruchs 8 gelöst. Danach ist die erfindungsgemäße Sensoranordnung dadurch gekennzeichnet, dass in dem Einflussbereich des Sensor eine Folie aus weichmagnetischem Material angeordnet ist, wobei sich die Permeabilität der Folie unter Einfluss eines Magnetfelds in Abhängigkeit der Feldstärke des Magnetfelds ändert und dass eine Auswerteschaltung vorgesehen ist, mittels der die Änderung der Permeabilität der Folie aus deren Rückwirkung auf den Sensor bestimmt und auf die Position und/oder Positionsänderung des Messobjekt relativ zu dem Sensor geschlossen wird und dass eine mit Gleichstrom erregte Kompensationsspule vorgesehen ist, mit der die Permeabilität der Folie oder eines Teils der Folie beeinflusst wird. Auch hier sei angemerkt, dass der Bestimmung einer Position oder Positionsänderung gleichgestellt ist die Bestimmung eines Winkels, einer Winkeländerung oder einer Drehzahlmessung.

Eine alternative Ausgestaltung einer erfindungsgemäßen Sensoranordnung, die die voranstehende Aufgabe löst, ist mit dem nebengeordneten Patentanspruch 12 beansprucht. Danach ist die insoweit erfindungsgemäße Sensoranordnung dadurch gekennzeichnet, dass in dem Einflussbereich des Sensors eine Folie aus weichmagnetischem Material angeordnet ist, wobei sich die Permeabilität der Folie unter Einfluss eines Magnetfelds in Abhängigkeit der Feldstärke des Magnetfelds ändert und wobei eine Bewegung des Messobjekts im Wesentlichen in Richtungen parallel zu einer Ausdehnungsrichtung der Folie erfolgt, wodurch in der Folie ein Bereich hoher Permeabilität, ein Bereich reduzierter Permeabilität und ein Übergangsbereich zwischen den beiden Bereichen entsteht, dass in Abhängigkeit des Abstands zwischen Sensor und Messobjekt der Übergangsbereich entlang der Folie verschoben wird und dass die Änderung der Permeabilität der Folie aus deren Rückwirkung auf den Sensor und daraus die Position und/oder Positionsänderung des Messobjekt relativ zu dem Sensor geschlossen wird. Auch hier sei angemerkt, dass der Bestimmung einer Position oder Positionsänderung gleichgestellt ist die Bestimmung eines Winkels, einer Winkeländerung oder einer Drehzahlmessung.

Ein auf diese alternative Ausgestaltung gerichtetes Verfahren, das die voranstehende Aufgabe löst, ist mit dem Patentanspruch 17 gelöst. Danach ist dieses Verfahren dadurch gekennzeichnet, dass durch einen dem Messobjekt zugeordneten Magneten in einer weichmagnetischen Folie, deren Permeabilität sich unter Einfluss eines Magnetfelds in Abhängigkeit der Feldstärke des Magnetfelds ändert und die in dem Einflussbereich des Sensors angeordnet ist, eine Änderung der Permeabilität der Folie hervorgerufen wird, wodurch in der Folie ein Bereich hoher Permeabilität, ein Bereich reduzierter Permeabilität und ein Übergangsbereich zwischen den beiden Bereichen entsteht, dass in Abhängigkeit des Abstands zwischen Sensor und Messobjekt der Übergangsbereich entlang der Folie verschoben wird und dass die Änderung der Permeabilität der Folie aus deren Rückwirkung auf den Sensor und daraus die Position und/oder Positionsänderung des Messobjekt relativ zu dem Sensor bestimmt wird

In erfindungsgemäßer Weise ist zunächst erkannt worden, dass eine Eigenschaft weichmagnetischer Materialien für eine hochgenaue Positionsmessung genutzt werden kann. Unter Einfluss eines äußeren Magnetfelds verändert sich die Permeabilität weichmagnetischer Materialien in Abhängigkeit der jeweils vorhandenen Feldstärke.

Diese Eigenschaft kann in einer Sensoranordnung zur Anwendung kommen. Dazu ist einem Messobjekt, dessen Position relativ zum Sensor erfasst werden soll, ein Magnet zugeordnet. Durch diesen Magneten steigt bei Annäherung des Messobjekts an den Sensor bzw. bei Annäherung des Sensors an das Messobjekt die magnetische Feldstärke im Bereich des weichmagnetischen Materials. Dadurch sinkt dessen Permeabilität, was sich auf die Eigenschaften eines in der Nähe des weichmagnetischen Materials angeordneten Messelementes auswirkt und über eine geeignete, mit dem Messelement verbundene Auswerteschaltung einem Wert für die Position oder Positionsänderung des Messobjekts zugeordnet werden kann. Geeignete Messelemente sind beispielsweise Magnetfeldsensoren wie z.B. Hallsensoren, AMR- und GMR-Sensoren, oder induktive Sensoren wie z.B. Spulen eines induktiven Sensors oder eines Wirbelstromsensors oder jedes andere Messelement, das auf Änderungen der Permeabilität empfindlich ist.

Erfindungsgemäß ist ferner erkannt worden, dass eine Verbesserung der Empfindlichkeit der Sensoranordnung dadurch erreicht werden kann, dass das weichmagnetische Material lediglich als dünne Folie ausgebildet ist. Damit wird das Entstehen von Volumeneffekten weitestgehend vermieden, wodurch für Änderungen der Permeabilität geringere Feldstärken notwendig sind und in kürzerer Zeit ablaufen können. Dies wirkt sich günstig auf die Empfindlichkeit und Dynamik der Sensoranordnung aus. Umgekehrt führt dies dazu, dass das Magnetfeld des dem Messobjekt zugeordneten Magneten in einem relativ weiten Messbereich Einfluss auf die Permeabilität der Folie nimmt.

Bei Bewegungen zwischen Messobjekt und Sensor in Richtungen, die im Wesentlichen parallel zu einer Ausdehnungsrichtung der Folie verlaufen, entstehen in der Folie ein Bereich hoher Permeabilität, ein Bereich reduzierter Permeabilität und ein Übergangsbereich zwischen den beiden Bereichen. Im Rahmen einer Ausgestaltung der Erfindung wird in Abhängigkeit des Abstands zwischen Sensor und Messobjekt der Übergangsbereich entlang der Folie verschoben. Dadurch wird über einen vergleichsweise großen Messbereich hinweg eine hohe Beeinflussung des Messelements bewirkt.

Von besonderem Vorteil ist eine derart konfigurierte Sensoranordnung, bei der die Magnetfeldrichtung des Magneten des Messobjekts entlang einer Achse "schwerer" Magnetisierung der Folie liegt. In diesem Fall besitzt das Magnetfeld des Magneten eine Kopplung nur kleiner Fläche der Stirnseite der Folie. Ebenfalls vorteilhaft ist, wenn der ungesättigte Bereich der Folie effektiv genutzt werden kann.

Die Auflösung und Genauigkeit der erfindungsgemäßen Sensoranordnungen ist abhängig von den elektromagnetischen und mechanischen Eigenschaften der Folie. Es können beispielsweise Folien aus M-Metall, Vitrovac oder Ferrit benutzt werden.

Vorteilhaft ist eine Kombination aus hoher mechanischer Festigkeit und sehr guten elektromagnetischen Eigenschaften, die man beispielsweise durch die Verwendung einer Folie aus nanokristallinem Material erreicht. Zu den sehr guten elektromagnetischen Eigenschaften gehören eine große magnetische Permeabilität (beispielsweise $\mu = 50\,000 \ldots 500\,000$), eine relativ kleine elektrische Leitfähigkeit und kleine Verluste in großen Temperatur- und Frequenzbereichen.

Die beschriebenen Effekte lassen sich erfindungsgemäß durch die nachfolgend beschriebenen Ausgestaltungen nutzen. Ziel dieser Ausgestaltungen ist es, einen Sensor mit möglichst großem Detektionsbereich zu schaffen und eine möglichst hohe Empfindlichkeit des Sensors zu erreichen.

Erfindungsgemäß wird eine Folie aus weichmagnetischem Material eingesetzt, deren Permeabilitätsänderung sich auf eine Sensorspule auswirkt.

Die Änderung der Permeabilität erzeugt eine detektierbare Rückwirkung auf die Spule, die sich meist in einer Änderung der Impedanz der Spule niederschlägt. Die Impedanz bzw. die Impedanzänderung der Spule kann in üblicher Weise gemessen werden, indem die Sensorspule beispielsweise mit Wechselstrom beaufschlagt wird.

Es sei jedoch betont, dass die Permeabilitätsänderung auch mit anderen induktiven oder magnetfeldempfindlichen Messelementen erfasst werden kann.

In Rahmen einer Ausgestaltung der Erfindung ist in der Nähe der weichmagnetischen Folie zusätzlich zu der mit einem Wechselstrom beaufschlagten Sensorspule eine Kompensationsspule angeordnet, die mit Gleichstrom erregt wird. Dadurch kann - je nach Ausbildung und Anordnung der Spule - die Permeabilität in einem mehr oder weniger großen Bereich der Folie beeinflusst werden. Dies kann genutzt werden, um gezielt besonders günstige Bedingungen für die Detektion des Messobjekts entstehen zu lassen. Befindet sich das Messobjekt in einem relativ großen Abstand, so wird das Magnetfeld des dem Messobjekt zugeordneten Magneten lediglich geringen Einfluss auf die Folie nehmen, da sich die Empfindlichkeit der Sensoranordnung in einem ungünstigen Bereich befindet. Durch Beaufschlagen der Kompensationsspule mit einem Gleichstrom kann eine Verschiebung der Empfindlichkeitskennlinie erreicht und die Empfindlichkeit an einem bestimmten Teil des Messbereichs gezielt erhöht werden. Andererseits könnte die Feldstärke bereits zu hohe Werte angenommen haben, wenn sich beispielsweise das Messobjekt sehr nahe an dem Sensor befindet. Durch die Kompensationsspule kann die Feldstärke dann gezielt reduziert werden, so dass die Sensoranordnung sich wieder in einem günstigeren Betriebszustand befindet. Auf diese Weise kann in Abhängigkeit der Polarität und Stärke des Gleichstroms der Messbereich erheblich ausgedehnt und die Empfindlichkeit über den Messbereich verbessert werden. Ferner können durch Einstellung des Magnetfelds der Kompensationsspule Einbautoleranzen oder langsam veränderliche Störungen, wie Temperaturdrift oder Alterung, kompensiert bzw. ausgeregelt werden.

Beide Ausgestaltungen können auch gleichzeitig realisiert sein, wodurch sich die positiven Effekte beider Ausgestaltungen addieren.

Bei der Ausgestaltung mit einer gleichstromerregten Kompensationsspule ist vorteilhafter Weise der Gleichstrom einstellbar. Dies kann sich zum einen lediglich auf die Stärke des Gleichstroms beziehen, zum anderen könnte auch dessen Polarität geändert werden. Durch Einstellen der Stärke des Gleichstroms lässt sich das Maß der Beeinflussung der Permeabilität der weichmagnetischen Folie verändern. Eine Änderung der Polarität bewirkt, dass das resultierende Magnetfeld, das sich aus den Magnetfeldern der Sensorspule, der Kompensationsspule und dem Magneten des Messobjekts ergibt, erhöht oder reduziert wird. Dadurch kann besonders umfangreich auf das die Permeabilität der Folie beeinflussende Magnetfeld eingewirkt werden. Dabei könnte der Gleichstrom derart eingestellt werden, dass sich ein im Wesentlichen konstantes Magnetfeld der Sensorspule einstellt.

In vorteilhafter Weise wird der Sensor, insbesondere vor der ersten Inbetriebnahme, einer Kalibrierung unterzogen. Dazu werden vorzugsweise die folgenden Schritte durchgeführt. In einem ersten Schritt wird das Messobjekt an einer Vielzahl von Positionen $h$ relativ zu dem Sensor positioniert. Dabei besitzen die einzelnen Positionen $h$ eine Schrittweite $\delta h$. Vorzugsweise sind die einzelnen Positionen derart angeordnet, dass sie sich im Wesentlichen auf einer gemeinsamen Linie befinden.

An jeder der Positionen $h$ wird ein Wechselstrom in die Sensorspule eingespeist. Dadurch erzeugt die Sensorspule ein elektromagnetisches Wechselfeld, das durch die weichmagnetische Folie beeinflusst wird. Für jede der Positionen $h$ wird die Impedanz $Z$ und/oder die relative Impedanzänderung $\Delta Z/Z$ der Spule bestimmt. Dazu sind verschiedene Verfahren aus der Praxis bekannt. Aus den so ermittelten Werten wird eine Kennlinie bestimmt, die eine Abhängigkeit zwischen der relativen Empfindlichkeit $S$ der Sensorspule und der Position $h$ des Messobjekts relativ zu der Sensorspule beschreibt. Dabei ist die relative Empfindlichkeit S gegeben durch

$$ S = \frac{\Delta Z}{Z} \bigg/ \delta h . $$

Aus dieser Kennlinie wird eine Position $h_0$ bestimmt, an der die relative Empfindlichkeit $S$ einen maximalen Wert annimmt. Der zu dieser Position $h_0$ korrespondierende Wert $Z_0$ der komplexen Impedanz wird in einem nicht flüchtigen Speicher abgespeichert. Mit diesen Schritten wurde somit die Kennlinie des Sensors bestimmt.

In den nächsten Schritten wird die Abhängigkeit der Messergebnisse von der Stärke des Gleichstroms bestimmt. Dazu wird zunächst ein Gleichstrom in die Kompensationsspule eingespeist. Wiederum wird das Messobjekt an verschiedenen Positionen $h$ platziert und die Impedanz $Z$ und/oder relative Impedanzänderung

$\Delta Z/Z$ der Spule an jeder Position $h$ bestimmt. Dabei wirkt auf die Folie die Überlagerung der Magnetfelder der Sensorspule, der Kompensationsspule und des Magneten des Messobjekts. In einem nächsten Schritt wird die Stärke des Gleichstroms im Messbereich $\pm\Delta h$ variiert. Dies wird solange wiederholt, bis ein vorbestimmter und gespeicherter Sollwert der Impedanz erreicht wird. Aus den so bestimmten Werten wird die Abhängigkeit des Gleichstroms von der Positionsänderung des Messobjekts ermittelt. Dabei hat sich gezeigt, dass in dem Messbereich $\pm\Delta h$ ein im Wesentlichen linearer Zusammenhang zwischen der Position $h$ und dem Gleichstrom durch die Kompensationsspule ergibt. Daher kann es in vielen Anwendungsfällen genügen, lediglich den Proportionalitätsfaktor zwischen Positionsänderung und dem Gleichstrom zu bestimmen und zu speichern.

Vorteilhaft ist, wenn der vorbestimmte Sollwert der komplexen Impedanz bei einen Grundabstand zwischen Messobjekt und dem Sensor ermittelt wird, bei welchem die Positionsänderungen des Messobjekts zu maximalen Impedanzänderungen des Spulensystems führt.

Im Allgemeinen wird zur Bestimmung der Rückwirkung der Änderung der Permeabilität der Folie auf die Spule deren Impedanz bzw. -änderung gemessen. Allerdings sei angemerkt, dass die Messung der Permeabilität prinzipiell auch auf andere Art und Weise bestimmt werden könnte. Die Messung der Impedanz kann direkt oder indirekt erfolgen. So kann beispielsweise bei Einprägung eines bekannten Stroms die über der Spule abfallende Spannung gemessen und durch Division der Spannung durch den Strom die Impedanz bestimmt werden. Allerdings könnte die Impedanz auch durch eine parallel geschaltete Kapazität zu einem freischwingenden Oszillator erweitert werden, der beispielsweise über eine PLL (Phase Locked Loop)-Schaltung angesteuert wird. Aus dem Ausgangssignal der PLL-Schaltung kann auf die Impedanz der Sensorspule geschlossen werden.

Aus der komplexen Impedanz $Z$ der Sensorspule lässt sich der Realteil Re$\{Z\}$ und der Imaginärteil Im$\{Z\}$ bestimmen. Die Bestimmung des Real- und Imaginärteils kann analog oder digital erfolgen. Entsprechende Verfahren sind aus der Praxis hinlänglich bekannt. Zusätzlich könnte der Quotient $D$ aus dem Realteil Re$\{Z\}$ und dem Imaginärteil Im$\{Z\}$ gebildet werden, wobei für den Quotienten $D$ gilt:

$$D = \mathrm{Re}\{Z\}/\mathrm{Im}\{Z\}.$$

Nach einer bevorzugten Ausführungsform der Erfindung wird die Größe des Gleichstroms durch die Kompensationsspule in einer Nachlaufsteuerung mittels eines geschlossenen Regelkreises eingestellt. Der Quotient $D$ kann hierbei als Sollwert für den Regelkreis dienen, wobei $D$ konstant gehalten werden könnte. Aus dem Imaginärteil Im$\{Z\}$ könnte die Position oder Positionsänderung des Messobjekts relativ zu dem Sensor ermittelt werden. Zusätzlich oder alternativ könnte die Stärke des Gleichstroms durch die Kompensationsspule dann zur Positionsbestimmung herangezogen werden.

Vorzugsweise erfolgt die Regelung derart, dass eine maximale relative Empfindlichkeit $S$ des Sensors über den gesamten Messbereich oder zumindest einen Teil hiervon konstant gehalten wird. Dazu könnten die aus einer Kalibrierung gewonnenen Informationen verwendet werden. Maximale Empfindlichkeit liegt bei der Position $h_0$ vor, die durch Wahl eines Gleichstroms durch die Kompensationsspule verschoben werden kann.

Alternativ zu einer Regelung könnte der Gleichstrom manuell eingestellt werden. Insbesondere bei Bewegungen des Messobjekts mit hoher Dynamik könnte die Regelung nicht ausreichend schnell auf Änderungen reagieren. Eine manuelle Einstellung des Gleichstroms lässt sich auf verschiedenste Art und Weise realisieren. So könnte die Stärke des Gleichstroms beispielsweise über Tasten oder eine Tastatur eingegeben werden. Alternativ oder zusätzlich könnten analoge oder digitale Dreh- oder Schieberegler Verwendung finden.

Bei der Sensoranordnung, die über eine gleichstromerregte Kompensationsspule verfügt, werden sich die Magnetfelder der Sensorspule, der Kompensationsspule und des Magneten des Messobjekts zu einem resultierenden Magnetfeld überlagern. Dabei werden die Richtungen und Polarität der einzelnen Magnetfelder im Allgemeinen unterschiedlich sein. Das Magnetfeld der Sensorspule ist bedingt durch die Speisung mit einem Wechselstrom ein Wechselfeld und ändert somit mit der doppelten Frequenz des Wechselstroms seine Polarität. Das Magnetfeld der Kompensationsspule wird in Abhängigkeit von der Position des Messobjekts relativ zu dem Sensor über eine Regelung oder manuell eingestellt. Dabei kann die Polarität des die Kompensationsspule erregenden Gleichstroms derart gewählt werden, dass die statische Feldkomponente des Magnetfelds erhöht oder abgesenkt wird. Dies wird davon abhängen, in welche Richtung das resultierende Magnetfeld verschoben werden soll, um möglichst gute oder gar ideale Bedingungen zur Messung der Positionen zu erzielen. Das Magnetfeld des dem Messobjekt zugeordneten Magneten wird im Allgemeinen ein inhomogenes Magnetfeld sein und von dem Abstand zwischen Sensor und Messobjekt abhängen.

Die Sensorspule und die Kompensationsspule könnten galvanisch voneinander getrennt sein. Dadurch lassen sich die beiden Spulen vollständig unabhängig voneinander mit Strömen beaufschlagen. Es sei jedoch darauf hingewiesen, dass die beiden Spulen auch zu einer einzelnen Spule zusammengefasst werden könnten oder eine der beiden Spulen durch einen Zwischenabgriff als Teilabschnitt der anderen Spule ausgestaltet sein kann. Bei Ausgestaltung durch eine einzelne Spule würde ein um einen Gleitstromanteil verschobener Wechselstrom in die Spule eingespeist. Der Offset könnte ebenso wie bei galvanisch getrennter Ausgestaltung der beiden Spulen mittels eines Regelkreises oder manuell eingestellt werden.

Bei dem Magneten des Messobjekts handelt es sich vorzugsweise um einen Permanentmagneten. Dadurch kann das Messobjekt unabhängig von jeglicher weiterer Energiezufuhr genutzt werden. Allerdings könnte der Magnet auch durch einen Elektromagneten gebildet sein. Dadurch könnte weiter auf die Messung Einfluss genommen werden. Befindet sich das Messobjekt beispielsweise vergleichsweise nahe an dem Sensor, so könnte durch Reduzierung des Erregerstroms das Magnetfeld des Magneten reduziert werden. Ebenso könnte bei großem Abstand zwischen Messobjekt und Sensor der Erregerstrom erhöht werden. Beide Ausgestaltungen des Magneten könnten auch kombiniert angewendet werden.

In einer möglichen Ausgestaltung der Auswerteschaltung für den Sensor ist die Folie kapazitiv mit der Sensorspule gekoppelt. Die Folie weist in dieser Ausgestaltung einen elektrischen Kontakt auf, der mit einem Oszillator verbunden ist. Der andere Pol des Oszillators ist mit einem der Anschlüsse der Sensorspule verbunden. Auf diese Weise würde die Energie kapazitiv in die Sensorspule eingekoppelt werden. Die beiden Anschlüsse der Sensorspule sind mit den Eingängen eines Verstärkers verbunden, der die über der Sensorspule abfallende Spannung verstärkt. Der Verstärker ist dabei Teil der Auswerteschaltung, mittels der die Änderung der Permeabilität der Folie bestimmt wird. Die über der Spule abfallende Spannung wird durch den Verstärker verstärkt und als verstärktes Signal $U_2$ ausgegeben. Dieses Signal $U_2$ ist proportional zu der relativen Impedanzänderung $\Delta Z/Z$.

Alternativ zu dieser Ausgestaltung könnte der Oszillator direkt mit der Sensorspule verbunden sein. Der Wechselstrom würde also direkt in die Spule eingekoppelt werden. Die Folie könnte dann beispielsweise mit Masse verbunden sein. Auch bei dieser Ausgestaltung würde die über der Sensorspule abfallende Spannung verstärkt und ein zur relativen Impedanzänderung $\Delta Z/Z$ proportionales Signal $U_2$ ausgegeben werden.

In beiden Fällen könnte eine elektronische Anordnung vorgesehen sein, die aus dem Spannungssignal $U_2$ zwei orthogonale Spannungskomponenten bildet. Die beiden Komponenten sind dann proportional zum Realteil Re{$Z$} bzw. Imaginärteil Im{$Z$} der komplexen Impedanz $Z$ der Sensorspule. Die elektronische Anordnung würde Spannungssignale $U_3$ und $U_4$ ausgeben, die die beiden orthogonalen Spannungskomponenten repräsentieren. Das Signal $U_4$ könnte zur Synchronisation des Oszillators herangezogen werden, während das Signal $U_3$ zur Steuerung der Spannungsquelle, die die Kompensationsspule mit einem Gleitstrom speist, genutzt wird.

Die elektronische Anordnung könnte durch verschiedenste aus der Praxis bekannte Anordnungen implementiert sein. Vorzugsweise erfolgt die Analyse der verstärkten Spannung digital. Die elektronische Anordnung würde dann einen A/D-Wandler, einen Prozessor und einen Speicher aufweisen. Zur galvanischen Trennung der elektronischen Anordnung von der Stromquelle könnte zusätzlich ein Optokoppler vorgesehen sein, über den die Steuerinformationen galvanisch entkoppelt an die Stromquelle übergeben werden.

Bei der Ausgestaltung der Sensoranordnung ohne Kompensationsspule und mit eingeschränkter Bewegungsrichtung des Messobjekts auf Richtungen, die im Wesentlichen parallel zu einer Ausdehnungsrichtung der Folie erfolgt, könnte der Magnet ebenso durch einen Permanentmagneten oder einen Elektromagneten realisiert sein. Bei Ausgestaltung durch einen Elektromagneten könnten wiederum auf das Messverhalten des Sensors - wie bereits zuvor beschrieben - Einfluss genommen werden.

Auch bei dieser Art der Ausgestaltung könnte eine Kalibrierung der Sensoranordnung durchgeführt werden. Dazu würden die zuvor beschriebenen Schritte zum Bestimmen der Kennlinie des Sensors entsprechend durchgeführt werden.

Die Ausgestaltung der Auswerteschaltung würde auf vergleichbare Art und Weise wie bei der Ausgestaltung mit Kompensationsspule erfolgen. Ein Oszillator könnte ein Spannungssignal direkt in einen Kontakt der Folie einspeisen. Die Spannung könnte dann kapazitiv in die Sensorspule eingekoppelt werden. Die an der Spule entstehende Spannung könnte wiederum über einen Verstärker verstärkt und einer elektronischen Anordnung zur Ermittlung des Real- und des Imaginärteils zugeführt werden. Aus einem dem Imaginärteil proportionalen Spannungssignal $U_4$ könnte eine Synchronisation des Oszillators herbeigeführt werden.

Ebenso könnte der Oszillator direkt mit der Sensorspule verbunden sein und der über der Spule entstehende Spannungsabfall über einen Verstärker verstärkt werden. Wiederum könnte das verstärkte Signal einer elektronischen Anordnung zugeführt werden, um aus dem verstärkten Signal den Real- und den Imaginärteil zu extrahieren.

Bei beiden erfindungsgemäßen Ausgestaltungen der Sensoranordnung - also der Sensoranordnung mit oder ohne Kompensationsspule - könnte der Sensor auf verschiedene Arten gebildet sein. So könnte der Sensor auf einem runden oder auf sonstige Art und Weise dreidimensional ausgeprägten Träger aufgebracht sein. Auf diesen Träger könnten die Sensorspule, die Folie und gegebenenfalls die Kompensationsspule gewickelt, geklebt oder auf sonstige Art und Weise aufgebracht sein.

In einer alternativen Ausgestaltung könnte der Sensor flächig ausgestaltet sein. Dabei ist der Sensor vorzugsweise auf einem planen Träger aufgebracht. Allerdings könnte der Träger auch gekrümmt und an spezielle Arbeitsumgebungen angepasst sein. Nach entsprechenden Kalibrierungsmaßnahmen können derartige Sensoren problemlos eingesetzt werden.

Für eine weitere Verbesserung der Empfindlichkeit der Sensoranordnung könnte die Dicke der Folie an die Eindringtiefe des durch die Sensorspule erzeugten elektromagnetischen Felds angepasst sein. Dabei ist das durch die Sensorspule erzeugte elektromagnetische Feld vorzugsweise hochfrequent. Für die Eindringtiefe $\delta$ in ein leitfähiges Material gilt:

$$\delta \propto \frac{1}{\sqrt{\omega \sigma \mu}}$$

wobei $\omega = 2\pi f$ mit $f$ als Frequenz des Wechselfeldes gilt und $\sigma$ die Leitfähigkeit und $\mu$ die Permeabilität der Folie sind. Wie zu erkennen ist, ist $\delta$ umgekehrt proportional zu der Wurzel aus der Permeabilität $\mu$ der Folie. Sinkt also bedingt durch ein äußeres Magnetfeld die Permeabilität der Folie, so steigt die Eindringtiefe des elektromagnetischen Felds in die Folie. Ist die Dicke der Folie geeignet dimensioniert, so dringt das elektromagnetische Feld in Bereichen mit niedriger Permeabilität durch die Folie hindurch. Dieser Effekt kann weiter zu einer Erhöhung der Empfindlichkeit genutzt werden. Es könnte nämlich auf der der Sensorspule abgewandten Seite nahe der Folie eine leitfähige Fläche angeordnet sein. Dabei weist diese leitfähige Fläche vorzugsweise eine im Vergleich zu der weichmagnetischen Folie wesentlich höhere Leitfähigkeit auf. Dadurch würden in der leitfähigen Fläche in höherem Maße Wirbelströme induziert als in der weichmagnetischen Folie.

Insbesondere bei Einschränkung der Bewegung des Messobjekts in Richtungen im Wesentlichen parallel zu einer Ausdehnungsrichtung der Folie wird erreicht, dass die weichmagnetische Folie die dahinter liegende leitfähige Fläche in Abhängigkeit der Position des Messobjekts freigibt. Je nach Position des Messobjekts würde eine unterschiedlich breite Zone mit reduzierter Permeabilität die weichmagnetische Folie für das elektromagnetische Feld der Sensorspule durchlässig werden lassen. (Dies kann anschaulich derart vorgestellt werden, dass die Folie ähnlich einer Jalousie einen unterschiedlich großen Teil einer Fensteröffnung freigibt.) Dadurch würden in Abhängigkeit der Position des Messobjekts in unterschiedlich starkem Maße Wirbelströme in der leitfähigen Fläche induziert. Diese bewirken eine stärkere Beeinflussung der Impedanz der Sensorspule als die in der weichmagnetischen Folie induzierten Wirbelströme, was sich wiederum positiv auf die Empfindlichkeit der Sensoranordnung auswirkt.

In vorteilhafter Weise wird die Sensorspule mit einem Wechselstrom mit hoher Frequenz gespeist. Damit ist die Dynamik des Sensors sehr hoch. Durch die hohe Frequenz ist zwar die Eindringtiefe der Wirbelströme in leitfähigen Materialien gering, was jedoch für dünne Folien (beispielsweise 20 $\mu$m) ausreicht. Es ist zu erkennen, dass ein Volumeneffekt nicht nötig oder sogar nicht gewünscht ist: Bei einem voluminösem weichmagnetischen Material würde der Wirbelstrom ebenfalls nur in einer dünnen Schicht fließen, so dass der Messeffekt in Verhältnis zum Volumen gering ist.

Wie zuvor beschrieben, ist die Zone der Permeabilitätsänderung abhängig von der Magnetfeldstärke. Je nach Magnet kann der Sensor dessen Position in relativ weitem Abstand (z.B. 30...50 mm) mit sehr hoher Auflösung (einige $\mu$m) messen, indem durch eine geeignete Anordnung die Zone höchster Empfindlichkeit gerade so gelegt wird, dass der Arbeitspunkt bei dem vorgegebenen Grundabstand des Magneten relativ zum Sensor liegt. Bei geeigneter Ausgestaltung des Magnetkreises ist ein sogenannter Redundanzfaktor von typischer Größenordnung 3 erreichbar. Das bedeutet, dass die Strecke der Bewegung des Messobjektes um den Faktor 3 größer ist als die Änderung der Verteilung der Permeabilität in der Folie. Die Länge der Folie ist damit um den Redundanzfaktor gegenüber der Strecke der Bewegung verkürzt. Dies ist besonders vorteilhaft, weil dadurch eine kurze und kompakte Bauform derartiger Sensoren ermöglicht wird.

Die zuvor beschriebenen Ausgestaltungen der Sensoren können auch derart realisiert sein, dass die Folie und der Magnet feststehend sind und lediglich die Spule bewegt wird.

In einer weiter vorteilhaften Ausgestaltung kann der Magnet fest mit dem Sensor verbunden sein. Um am Ort der Sensorspule ein von der Position des Messobjektes veränderliches Magnetfeld zu erhalten, muss das Messobjekt aus einem Material bestehen, das Magnetfelder beeinflusst. Dies kann beispielsweise ein ferromagnetisches Material sein. Durch eine Positionsänderung des ferromagnetischen Messobjektes relativ zum Sensor und dem mit dem Sensor verbundenen Magneten werden die Magnetfeldlinien beeinflusst und damit ebenfalls eine Änderung der Verteilung der Permeabilität in der Folie bewirkt.

Es gibt nun verschiedene Möglichkeiten, die Lehre der vorliegenden Erfindung in vorteilhafter Weise auszugestalten und weiterzubilden. Dazu ist einerseits auf die den unabhängigen Ansprüchen jeweils nachgeordneten Patentansprüche und andererseits auf die nachfolgende Erläuterung bevorzugter Ausführungsbeispiele der Erfindung anhand der Zeichnung zu verweisen. In Verbindung mit der Erläuterung der bevorzugten Ausführungsbeispiele der Erfindung anhand der Zeichnung werden auch im Allgemeinen bevorzugte Ausgestaltungen und Weiterbildungen der Lehre erläutert. In der Zeichnung zeigen

Fig. 1    in einer schematischen Darstellung eine erfindungsgemäße Vorrichtung zur Erfassung der Position und/oder Positionsänderungen eines Messobjekts,

Fig. 2    ein Diagramm den Zusammenhang zwischen einer Magnetfeldverteilung entlang einer weichmagnetischen Folie und der Position $h$

des Messobjektes,

Fig. 3    ein Diagramm mit einem beispielhaften Verlauf der relativer Empfindlichkeit $S$ in Abhängigkeit der Position $h$ des Messobjekts relativ zu dem Sensor,

Fig. 4    ein Diagramm mit einem Verlauf des Gleichstroms I _ in Abhängigkeit der Position $h$ eines Messobjektes,

Fig. 5    ein erstes Ausführungsbeispiel einer erfindungsgemäßen Sensoranordnung mit einer Kompensationsspule,

Fig. 6    ein zweites Ausführungsbeispiel einer erfindungsgemäßen Sensoranordnung mit einer Kompensationsspule,

Fig. 7    ein drittes Ausführungsbeispiel einer erfindungsgemäßen Sensoranordnung mit einer Kompensationsspule und einem fest eingebauten Permanentmagneten und

Fig. 8    ein Schaltbild einer steuerbaren Stromquelle zur Ansteuerung der Gleichstromspule.

Bei den einzelnen Figuren sind für gleiche oder gleichartige Komponenten gleiche Bezugszeichen verwendet.

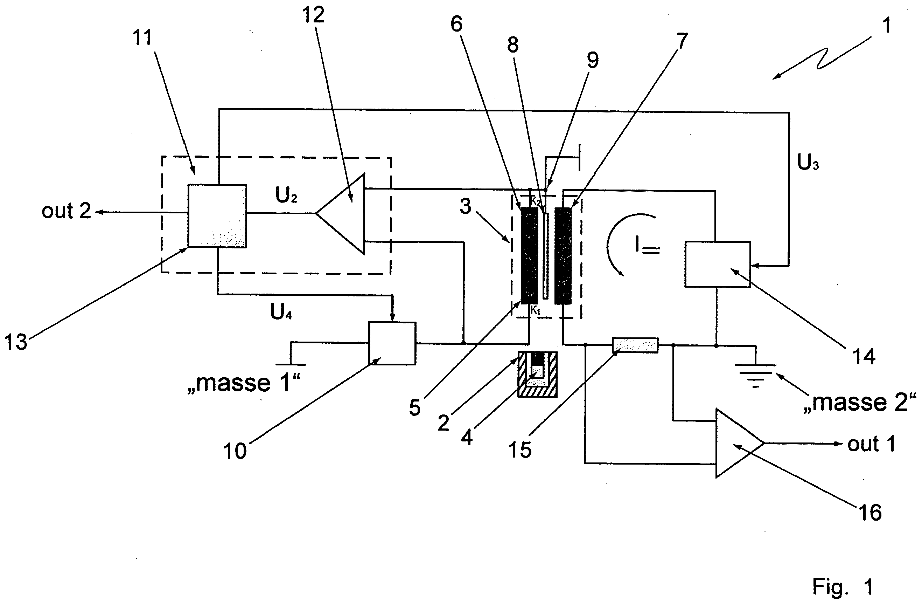

Fig. 1 zeigt in einer schematischen Darstellung ein Blockschaltbild einer erfindungsgemäßen Sensoranordnung 1 zur Erfassung der Position $h$ und/oder Positionsänderung eines Messobjekts 2 relativ zu einem elektromagnetischen Sensor 3. Dem Messobjekt 2 ist ein Magnet 4 in Form eines Permanentmagneten zugeordnet, der in der abgebildeten Ausführung von dem Messobjekt 2 zu nahezu allen Seiten hin umschlossen ist. Der Sensor 3 weist ein Spulensystem 5 auf, das aus einer Sensorspule 6 und einer Kompensationsspule 7 besteht. Im Einflussbereich des Spulensystems 5 ist eine Folie 8 aus weichmagnetischem Material angeordnet. Die Sensorspule 6 besitzt zwei Anschlüsse $K_1$ und $K_2$. Der Anschluss $K_1$ ist mit dem synchronisierbaren Oszillator 10 verbunden, der Anschluss $K_2$ ist mit dem Eingang einer Auswerteschaltung 11 und dem elektrischen Kontakt 9 der Folie verbunden. Der Oszillator 10 speist die Sensorspule 6 mit einer Wechselspannung fester Frequenz und Amplitude. Auf diese Weise wird durch die Sensorspule 6 ein elektromagnetisches Wechselfeld erzeugt, welches in der Folie 8 Wirbelströme induziert. Dabei beeinflussen die elektromagnetischen Eigenschaften, wie die elektrische Leiffähigkeit $\sigma$ und die magnetische Permeabilität $\mu$ des Materials der Folie 8, den Charakter und die Rückwirkung der Wirbelströme auf das Wechselfeld. Durch eine Abstandsänderung zwischen dem Messobjekt 2 und dem Sensor 3 ändert sich die magnetische Permeabilität $\mu$ der Folie 8, was zur Änderung des Wechselfeldes im Spulensystem 5 führt. Infolge dessen ändert sich die komplexe Impedanz $Z$ der Sensorspule 6, die mit Hilfe einer Auswerteschaltung 11 gemessen wird. Der Spannungsabfall zwischen den Anschlüssen $K_1$ und $K_2$ wird mit einem Differenzverstärker 12 verstärkt, wobei die Spannung $U_2$ am Ausgang des Verstärkers 12 proportional zur Impedanz $Z$ der Sensorspule 6 ist. Zu der Spannung $U_2$ werden durch eine elektronische Anordnung 13 zwei orthogonale Komponenten $U_3$ und $U_4$ ermittelt.

Die Spannung $U_3$ wird zum Steuern einer steuerbaren Spannungsquelle 14 verwendet, die die Kompensationsspule 7 des Spulensystems 5 mit einem Gleichstrom I _ speist. Dadurch wird durch die Kompensationsspule 7 ein konstantes Magnetfeld erzeugt, welches zusammen mit dem Magnetfeld des Permanentmagneten 4 und dem Wechselfeld der Sensorspule 6 ein resultierendes magnetisches Feld bildet. Die Größe des Gleichstromes I_ wird über den Spannungsabfall an einem stabilen Widerstand 15 mithilfe eines Integrators 16 gemessen. Das Signal am Ausgang "out1" des Integrators 16 wird zur Ermittlung der Abstandsänderungen zwischen dem Messobjekt 2 und dem Sensor 3 genutzt.

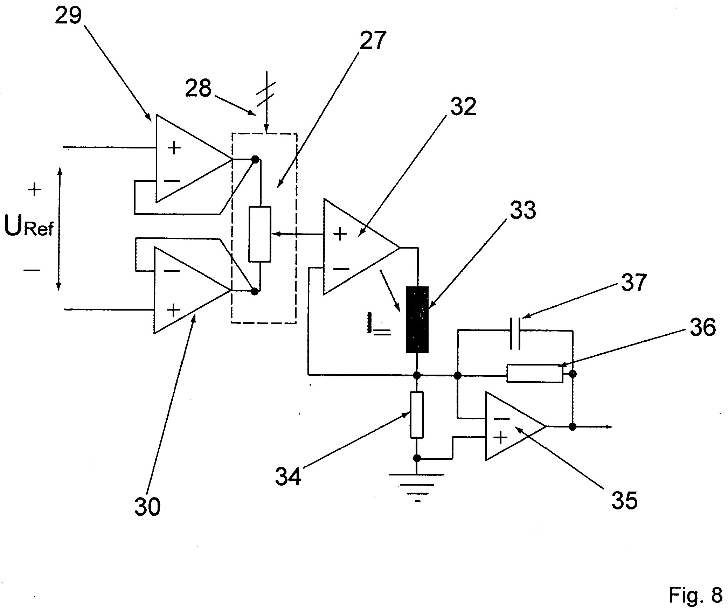

Die steuerbare Spannungsquelle 14 kann auf verschiedene Weise gebildet sein. Es kann ein D/A-Wandler oder ein Digitalpotentiometer eingesetzt werden, welche über das Signal $U_3$ angesteuert werden. Eine mögliche Ausgestaltung ist in Fig. 8 dargestellt und wird weiter unten detaillierter beschrieben.

Die zweite Spannungskomponente $U_4$, die durch die elektronische Anordnung aus der Spannung $U_2$ erzeugt wird, wird zur Synchronisation des Oszillators 10 genutzt. Dadurch sind die durch den Oszillator ausgegebene Spannung $U_1$ und die Spannung $U_4$ synchron.

Die Sensoranordnung 1 könnte in einem geschlossenen Regelkreis eingesetzt werden, wobei das Signal $U_3$ eine Stellgröße ist, die als Differenz zwischen einem Sollwert im Speicher der elektronischen Anordnung 13 und der Spannung $U_2$ bestimmt wird. Bei einer anderen Variante des Regelkreises wird das Signal $U_3$ unterbrochen und die Spannungsquelle 14 manuell, beispielsweise über eine Tastatur, gesteuert, um einen bestimmten Wert des Gleichstroms I _ zu erreichen. Das Ausgangssignal wird aus "out2" der elektronischen Anordnung 13 erzeugt.

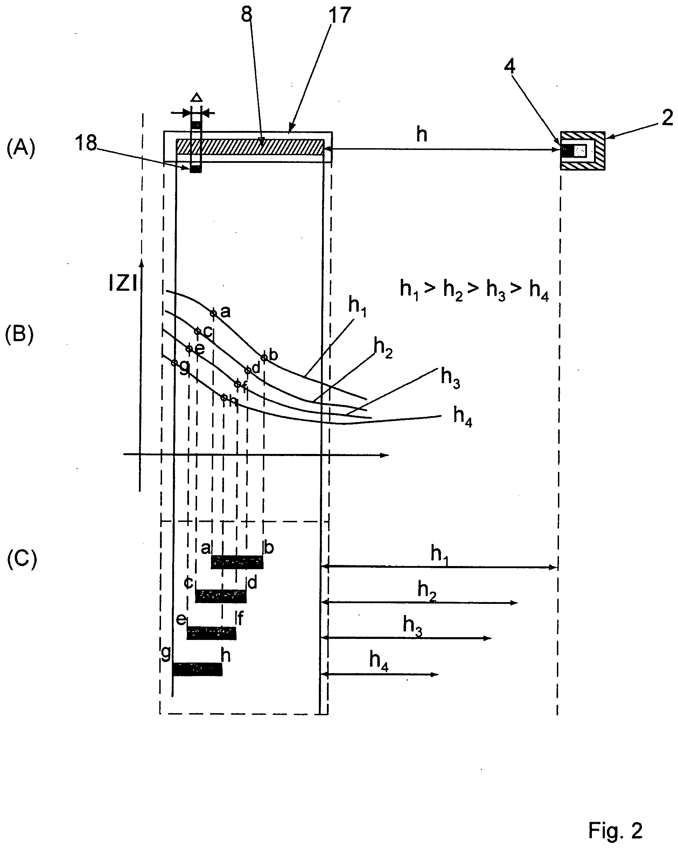

Anhand der Figuren 2(A), (B), (C) soll der Zusammenhang zwischen der Magnetfeldverteilung entlang der Folie 8 und der Position $h$ des Magneten 4 erläutert werden. Die Folie 8 besteht aus einem nanokristallinen Material und ist auf einen Träger 17, der beispielsweise aus Keramik besteht, aufgebracht. An dieser Figur 2 ist auch die Bedeutung des Redundanzfaktors erkennbar: Bei einer Änderung der Position des Messobjektes vom Abstand $h_1$ nach $h_4$ ändert sich die Verteilung der Permeabilität in der Folie nur um die Strecke von a-b bis g-h. Diese Strecke ist um den Redundanzfaktor gegenüber der zurückgelegten Strecke h des Messobjektes verkürzt, wobei der Redundanzfaktor beispielsweise den Werte 3 hat.

Fig. 2(A) zeigt eine Anordnung, die aus einer auf einem Träger 17 aufgebrachten Folie 8 besteht und mit der die Verteilung des durch einen Permanentmagneten 4 erzeugten Magnetfelds entlang der Folie 8 indirekt bestimmt werden kann. Eine Messspule 18 mit einer Breite $\Delta$ = 3mm ist einlagig um den Träger 17 und die Folie 8 herum angeordnet. Dabei ist die Messspule 18 derart ausgestaltet, dass sie in Längsrichtung der Folie 8 verschiebbar ist.

Das in Fig. 2(B) wiedergegebene Diagramm zeigt den Betrag der komplexen Impedanz der Messspule 18 bei Verschiebung der Messspule 18 in x-Richtung entlang der Folie 8 (Länge der Folie L = 25 mm, Breite 5 mm und Dicke 0,02 mm). Dabei sind mehrere Impedanzverläufe in dem Diagramm dargestellt, die sich bei verschiedenen Positionen $h$ des Messobjekts 2 relativ zu der Folie 8 ergeben. Zur Verdeutlichung seien als Zahlenwerte die Positionen $h_1$ = 60 mm, $h_2$ = 50 mm, $h_3$ = 40 mm und $h_4$ = 30 mm angegeben. Dies verdeutlicht auch, wie groß der Messbereich einer derartigen Anordnung eingestellt werden kann.

Das Diagramm in Fig. 2(C) zeigt schematisch die Bereich der Folie, in denen sich eine maximale Steilheit der Impedanzkennlinie und somit eine maximale Empfindlichkeit eines die weichmagnetische Folie verwendenden Sensors einstellt. Die Bereiche sind dabei für die Positionen $h_1$ = 60 mm, $h_2$ = 50 mm, $h_3$ = 40 mm und $h_4$ = 30 mm dargestellt. Es ist deutlich zu erkennen, dass die sich die Bereiche (a-b), (c-d), (e-f) und (g-h) proportional mit der Position h des Permanentmagneten 4 mitbewegen.

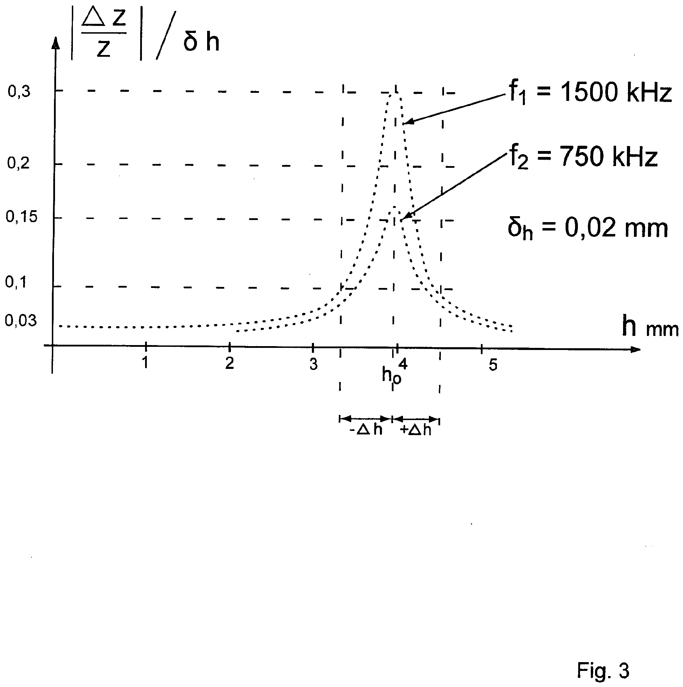

In Fig. 3 ist die relative Empfindlichkeit $S$ in Abhängigkeit von der Position h des Messobjekts 2 genauer dargestellt. Für die Empfindlichkeit $S$ des Sensors 3 gilt:

$$S = \frac{\Delta Z}{Z} \Big/ \delta h \quad ,$$

wobei $\Delta Z/Z$ die relativen Impedanzänderung der Sensorspule (7) und $\delta h$ die Schrittweite zwischen den einzelnen Positionen $h$ sind. Es ist deutlich zu erkennen, dass die relative Empfindlichkeit $S$ an der Position $h_0$ maximale Werte annimmt. In einem Bereich $\pm \Delta h$ um die Position $h_0$ herum bleibt die relative Empfindlichkeit S noch auf signifikanten Werten und ist danach erheblich reduziert.

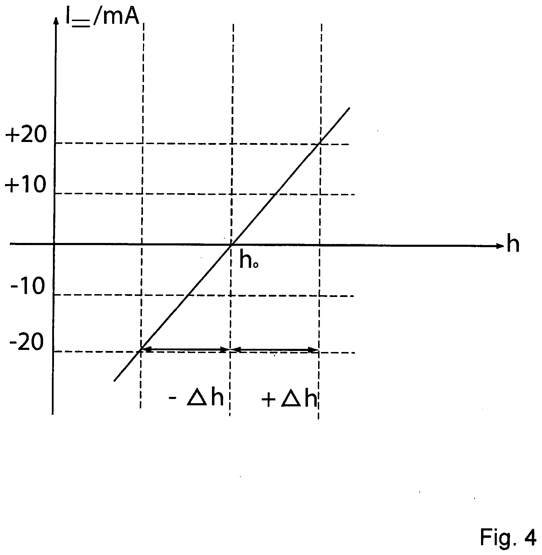

Fig. 4 zeigt ein Diagramm der Gleichstromverläufe, abhängig von der Positionsänderung $\pm \Delta h$ eines Messobjekts relativ zur Grundposition $h_0$. Das Diagramm zeigt, dass zwischen dem Gleichstrom I _ und den Positionsänderungen des Permanentmagneten $\pm \Delta h$ eine lineare Funktion eingelegt werden könnte.

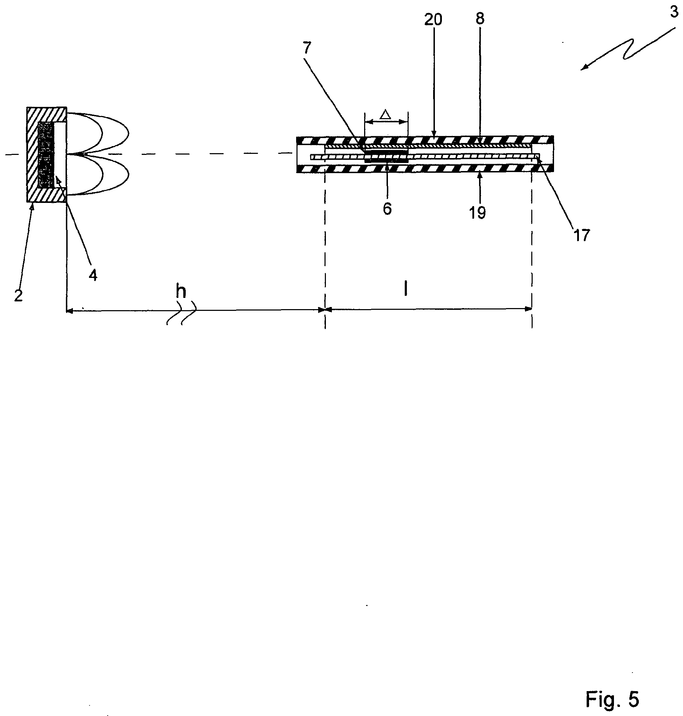

Fig. 5 zeigt ein erstes Ausführungsbeispiel einer erfindungsgemäßen Sensoranordnung, welche aus einem Messobjekt 2 und einem Sensor 3 besteht.

Ein Permanentmagnet 4 ist in ein Gehäuse des Messobjektes 2 so eingebaut, dass die Magnetfeldrichtung mit der Bewegungsachse des Messobjektes 2 übereinstimmt. Der Sensor 3 ist flächig ausgestaltet und enthält einen Träger 17, auf dem von beiden Seiten zwei planare Spulen 6 und 7 angeordnet sind.

Als Träger 17 könnte eine Leiterplatte oder ein Keramiksubstrat benutzt werden und die Spulen 6 und 7 könnten durch bekannte Verfahren günstig hergestellt werden, beispielsweise per Siebdruck auf dem Träger 17 aufgedruckt oder auf diesen aufgeklebt sein.

Der Träger 17 mit den Spulen 6 und 7 ist mit zwei Platten 19, 20 aus elektrisch leitendem Material, vorzugsweise Aluminium oder Kupfer abgedeckt. Die Breite "$\Delta$" der Spulen 6 und 7 beträgt nur ca. 25 % von der Länge "l" der Folie 8, welche an einer Seite der Platte 20 aufgeklebt ist. Die Spule 6 wird mit hochfrequenter Wechselspannung gespeist und dient als Messspule. Die Kompensationsspule 7 besteht aus mehreren Lagen und wird mit Gleichstrom gespeist.

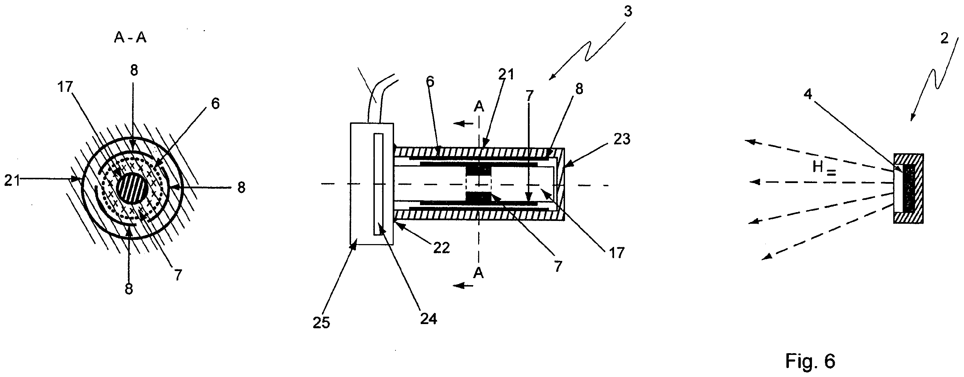

Fig. 6 zeigt ein zweites Ausführungsbeispiel eines erfindungsgemäßen Sensors. Der Sensor 3 besteht aus einem runden Träger 17, der beispielsweise aus einem Kunststoff hergestellt ist. Eine erste mehrlagige Spule, die als Kompensationsspule 7 dient und mit Gleichstrom gespeist wird, ist in einer Nut um den Träger 17 gewickelt.

Die Messspule 6, die durch einen Oszillator mit Wechselstrom höherer Frequenz gespeist wird, ist einlagig entlang des Trägers 17 gewickelt und umfasst die Kompensationsspule 7.

Eine Folie 8 aus nanokristallinem oder amorphem Material ist im Inneren eines Rohrs 21 eingeklebt. Das Rohr 21 besteht aus einem Material mit hoher elektrischer Leitfähigkeit und dient gleichzeitig als Sensorgehäuse. Von der Seite des Messobjektes 2 ist das Rohr 21 mit einem Deckel 23 aus elektrisch leitenden Material abgedeckt, welcher aber für das Dauermagnetfeld (H=) des Messobjektes 2 durchlässig ist. Die Auswerteelektronik 24 ist in ein Gehäuse 25 eingebaut, welches aus EMV-Gründen mit dem Rohr 21 und der Folie 8 verbunden werden sollte.

Vorteilhaft bei dieser Ausführungsform ist, dass der Sensor 3 komplett gekapselt und abgeschirmt ist und beispielsweise direkt ohne zusätzliches Druckrohr in einem Druckraum, beispielsweise eines Hydraulik- oder Pneumatikzylinders, eingebaut werden kann.

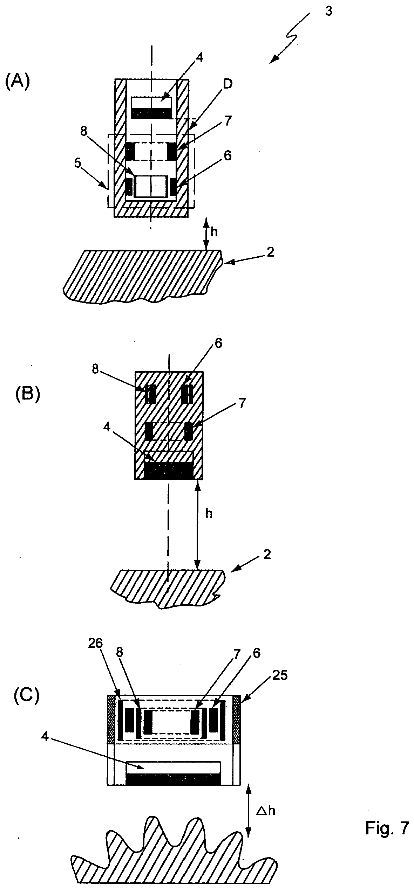

Fig. 7 zeigt eine dritte Ausführungsform eines Sensors 3, bei welcher ein Permanentmagnet 4 in einem bestimmten, festen Abstand D zu dem Spulensystem 5 des Sensors 3 angeordnet ist und sich nicht mit dem Messobjekt 2 bewegt.

Das Messobjekt 2 besteht aus einem ferromagnetischen Stahl und ist in einem Grundabstand h zu der Oberfläche des Sensors 3 angeordnet und bewegbar.

In einer ersten Variante (A) ist der Permanentmagnet 4 auf der vom Messobjekt 2 abgewandten Seite des Spulensystems 5 angeordnet. Diese Anordnung ist besonders vorteilhaft, wenn mit einem Sensor 3 geringer Größe, beispielsweise einem Durchmesser von 10 mm, relativ große Messbereiche, beispielsweise 15 mm, mit einer guten Linearität gemessen werden.

In einer zweiten Variante (B) ist der Permanentmagnet 4 zwischen dem Messobjekt 2 und dem Spulensystem 5 angeordnet. Diese Variante kann vorteilhaft benutzt werden, wenn kleine Positionsänderungen $\Delta$ h bei einem relativ großen Grundabstand h von beispielsweise 25...30 mm gemessen werden sollten und der Durchmesser des Sensors beispielsweise nur 10 mm beträgt.

In einer dritten Variante ist das Spulensystem 5 des Sensors 3, das aus zwei Spulen 6 und 7 besteht, auf einem Träger 17 konzentrisch gewickelt. Zwischen den Spulen 6 und 7 ist eine Folie 8 aus weichmagnetischem Material angeordnet, welche die Spule 7 umfasst. Die Spule 6 dient als eine Messspule, deren Impedanz bzw. der Imaginärteil Im Z der Impedanz vom Abstand h abhängt und gemessen wird. Die Spule 7 wird mit Gleichstrom gespeist und dient als Kompensationsspule. Darüber befindet sich ein Rohr 26 aus einem elektrisch gut leitfähigen Material, beispielsweise Aluminium oder Kupfer. Dann könnte das Gehäuse 25 kostengünstig aus nichtleitendem Material, beispielsweise aus Kunststoff, hergestellt werden. Der Gleichstrom könnte so nachgestellt (bzw. eingestellt) werden, dass bei Positionsänderungen $\Delta$ h zwischen dem Sensor 3 und dem Messobjekt 2 die Impedanz bzw. Im Z konstant bleibt. In diesem Fall ist die Höhe des Gleichstromes proportional zu Positionsänderungen $\Delta$ h. Das Messobjekt könnte auch eine profilierte Oberfläche ausweisen, beispielsweise ein Zahnrad oder ein Polrad, wodurch mit dem Sensor auch Drehzahlen und/oder Winkel gemessen werden können.

Fig. 8 zeigt eine Prinzipschaltung einer steuerbaren Gleichstromquelle zum Ansteuern der Kompensationsspule der Vorrichtung gemäß Fig. 1. Die Gleichstromquelle weist einen elektronisch einstellbaren Digital-Potentiometer 27 auf, der über eine Ansteuerleitung 28 durch eine Nachlaufsteuerung oder eine Tastatur angesteuert wird. Der Digital-Potentiometer 27 ist durch zwei Operationsverstärker 29, 30 symmetrisch mit einer Gleichspannung gespeist, wobei zwischen den nicht-invertierenden Eingängen der Operationsverstärker 29, 30 eine Referenzspannung $U_{Ref}$ anliegt. Der Schleifer 31 des Digital-Potentiometers 27 ist mit dem nicht-invertierenden Eingang eines weiteren Operationsverstärkers 32 verbunden. Zwischen dem Ausgang des Operationsverstärkers 32 und dessen invertierenden Eingang ist eine Spule 33 angeordnet, über die ein Gleichstrom I_ fließt. Die Spule 33 ist hier durch die Kompensationsspule 7 der Schaltung gemäß Fig. 1 gebildet. Die Höhe des Gleichstroms I_ wird durch einen Widerstand 34 in Abhängigkeit der Spannung am Ausgang der Operationsverstärkers 32 bestimmt, die wiederum von der Stellung der Schleifers 31 des Digital-Potentiometers abhängt. Dabei ist die Schaltung derart dimensioniert, dass bei der Mittelstellung des Schleifers 31 der Strom I_ gleich null ist. Abhängig von der Stellung des Schleifers kann ein positiver oder ein negativer Strom ausgegeben werden. In Abhängigkeit der Lage des Arbeitspunkts des Sensors wird die Polarität und die Höhe des Gleichstroms I_ derart eingestellt, dass im Bereich $\pm \Delta h$ eine konstante Empfindlichkeit des Sensors erreicht wird.

Die über dem Widerstand 34 abfallende Spannung wird über einen Integrator, der aus einem Operationsverstärker 35, einem Widerstand 36 und einer Kapazität 37 besteht, gemessen.

Schließlich sei angemerkt, dass die voranstehend erörterten Ausführungsbeispiele die beanspruchte Lehre lediglich erläutern, diese jedoch nicht auf die Ausführungsbeispiele einschränken.

**Bezugszeichenliste**

| | |
|---|---|
| 1 | Sensoranordnung |
| 2 | Messobjekt |
| 3 | Sensor |
| 4 | Magnet |
| 5 | Spulensystem |
| 6 | Sensorspule |
| 7 | Kompensationsspule |
| 8 | Folie |
| 9 | el. Kontakt (Folie) |
| 10 | Oszillator |
| 11 | Auswerteschaltung |
| 12 | Verstärker |
| 13 | elektronische Anordnung |
| 14 | Spannungsquelle |
| 15 | (Mess-) Widerstand |
| 16 | Integrator |
| 17 | Träger |
| 18 | Messspule |
| 19 | Träger (rund) |
| 20 | Rohr |
| 21 | el. Kontakt (Rohr) |
| 22 | Gehäuse |
| 23 | Auswerteschaltung |
| 24 | Träger (plan) |
| 25 | Abschirmung |
| 26 | leitfähige Fläche |
| 27 | Digital-Potentiometer |
| 28 | Ansteuerleitung |
| 29 | Operationsverstärker |
| 30 | Operationsverstärker |
| 31 | Schleifer (Poti) |
| 32 | Operationsverstärker |
| 33 | Spule |
| 34 | Widerstand |
| 35 | Operationsverstärker |
| 36 | Widerstand |
| 37 | Kapazität |

**Patentansprüche**

1. Verfahren zum Bestimmen der Position und/oder Positionsänderung eines Messobjekts relativ zu einem Sensor (2), wobei der Sensor (2) eine mit Wechselstrom beaufschlagte Sensorspule (7) aufweist, **dadurch gekennzeichnet, dass** durch einen dem Messobjekt (1) zugeordneten Magneten (5) in einer weichmagnetischen Folie (4), deren Permeabilität sich unter Einfluss eines Magnetfelds in Abhängigkeit der Feldstärke des Magnetfelds ändert und die in dem Einflussbereich des Sensors (2) angeordnet ist, eine Änderung der Permeabilität der Folie (4) hervorgerufen wird, dass die Änderung der Permeabilität der Folie (4) aus deren Rückwirkung auf den Sensor (2) und daraus die Position und/oder Positionsänderung des Messobjekt (1) relativ zu dem Sensor (2) bestimmt wird, und dass durch eine mit Gleichstrom erregte Kompensationsspule (8) ein Magnetfeld erzeugt wird, mittels dessen die Permeabilität der Folie (4) oder Teile der Folie (4) beeinflusst wird.

2. Verfahren nach Anspruch 1, **dadurch gekennzeichnet**, der Gleichstrom derart eingestellt wird, dass sich ein im Wesentlichen konstantes Magnetfeld der Sensorspule (7) einstellt.

3. Verfahren nach Anspruch 1 oder 2, **dadurch gekennzeichnet, dass** zum Kalibrieren des Sensors (2) die folgenden Schritte durchgeführt werden:

    Positionieren des Messobjekts (1) an einer Vielzahl von Positionen $h$ relativ zu dem Sensor (2) mit einer Schrittweite $\delta h$,
    Einspeisen eines Wechselstroms in die Sensorspule (7),
    Bestimmen der Impedanz $Z$ und/oder relativen Impedanzänderung $\Delta Z/Z$ der Sensorspule (7) an jeder der Positionen,
    Bestimmen einer Kennlinie, die eine Abhängigkeit der relativen Empfindlichkeit S der Sensorspule (7) von der Position h des Messobjekts (1) beschreibt, wobei

$$S = \frac{\Delta Z}{Z} \Big/ \delta h$$

    Bestimmen einer Position $h_0$ in der Kennlinie, bei der die relative Empfindlichkeit S maximale Werte annimmt,
    Speichern des Wertes der komplexen Impedanz $Z_0$, der der Position $h_0$ entspricht, in einen nichtflüchtigen Speicher,
    Einspeisen eines Gleichstroms in die Kompensationsspule (8)

    Bestimmen der Impedanz $Z$ und/oder relativen Impedanzänderung $\Delta Z/Z$ der Sensorspule (7) an jeder Position $h$, wobei auf die Folie (4) die Magnetfelder der Sensorspule (7), der Kompensationsspule (8) und des Magneten (5) einwirken,
    Ändern des Gleichstroms im Messbereich $\pm \Delta h$ bis ein gespeicherter Sollwert der Impedanz erreicht wird,
    Ermitteln der Abhängigkeit des Gleichstroms von der Positionsänderung des Messobjekts (1).

4. Verfahren nach einem der Ansprüche 1 bis 3, **dadurch gekennzeichnet, dass** zur Detektion der durch die Änderung der Permeabilität der Folie (4) hervorgerufene Rückwirkung auf die Sensorspule (7) eine Bestimmung der Impedanz bzw. deren Änderung durchgeführt wird.

5. Verfahren nach einem der Ansprüche 1 bis 4, **dadurch gekennzeichnet, dass** die Größe des Gleichstroms durch die Kompensationsspule (8) in einer Nachlaufsteuerung durch einen geschlossenen Regelkreis eingestellt wird, wobei der Quotient $D = \mathrm{Re}\{Z\}/\mathrm{Im}\{Z\}$ aus Realteil $\mathrm{Re}\{Z\}$ und Imaginärteil $\mathrm{Im}\{Z\}$ der komplexen Impedanz $Z$ der Sensorspule (7) als Sollwert für den Regelkreis herangezogen werden kann.

6. Verfahren nach Anspruch 5, **dadurch gekennzeichnet, dass** der Imaginärteil $\mathrm{Im}\{Z\}$ zur Ermittlung der Positionsänderung zwischen dem Messobjekt (1) und dem Sensor (2) benutzt wird, wobei $D$ konstant gehalten wird, oder dass die Stärke des Gleichstroms, der durch die Kompensationsspule (8) fließt, zur Positionsbestimmung herangezogen wird.

7. Verfahren nach Anspruch 5 oder 6, **dadurch gekennzeichnet, dass** durch die Regelung eine maximale relative Empfindlichkeit S des Sensors (2) über den gesamten Messbereich oder einem Teil hiervon konstant gehalten wird.

8. Sensoranordnung zum Bestimmen der Position und/oder Positionsänderung eines Messobjekts (1) relativ zu einem Sensor (2), wobei dem Messobjekt (1) vorzugsweise ein Magnet (5) zugeordnet ist und wobei der Sensor (2) vorzugsweise eine mit Wechselstrom beaufschlagte Sensorspule (7) aufweist, **dadurch gekennzeichnet, dass** in dem Einflussbereich des Sensor (2) eine Folie (4) aus weichmagnetischem Material angeordnet ist, wobei sich die Permeabilität der Folie (4) unter Einfluss eines Magnetfelds in Abhängigkeit der Feldstärke des Magnetfelds ändert und dass eine Auswerteschaltung (10) vorgesehen ist, mittels der die Änderung der Permeabilität der Folie (4) aus deren Rückwirkung auf den Sensor (2) bestimmt und auf die Position und/oder Positionsänderung des Messobjekt (1) relativ zu dem Sensor (2) geschlossen wird, und dass eine mit Gleichstrom erregte Kompensationsspule (8) vorgesehen ist, mit der die Permeabilität der Folie (4) oder eines Teils der Folie (4) beeinflusst wird.

9. Sensoranordnung nach Anspruch 8, **dadurch gekennzeichnet, dass** die Folie (4) kapazitiv mit der Sensorspule (7) gekoppelt ist und einen elektrischen Kontakt (6) ausweist, wobei
ein Oszillator (14) zwischen dem Kontakt (6) der Folie (4) und einem Anschluss (17) der Sensorspule (7) angeschlossen sein kann.

10. Sensoranordnung nach Anspruch 9, **dadurch gekennzeichnet, dass** ein zweiter Anschluss (18) der Sensorspule (7) mit einem Eingang eines Verstärkers (11) der Auswerteschaltung (10) verbunden ist, wobei ein durch den Verstärker (11) ausgegebenes Signal $U_2$ proportional zur relativen Impedanzänderung $\Delta Z/Z$ der Sensorspule (7) ist.

11. Sensoranordnung nach Anspruch 10, **dadurch gekennzeichnet, dass** eine elektronische Anordnung (12) zur Ermittlung zweier orthogonaler Komponenten der Spannung $U_2$ vorgesehen ist, wobei eine der beiden Komponenten proportional zum Realteil $Re\{Z\}$ und die andere proportional zum Imaginärteil $Im\{Z\}$ der komplexen Impedanz $Z$ der Sensorspule (7) sind und
dass die elektronische Anordnung (12) ggf. Signale $U_3$ und $U_4$ erzeugt, wobei durch das Signal $U_4$ der Oszillator (14) synchronisiert und das Signal $U_3$ zur Steuerung der Spannungsquelle (13) benutzt wird.

12. Sensoranordnung zum Bestimmen der Position und/oder Positionsänderung eines Messobjekts (1) relativ zu einem Sensor (2), wobei dem Messobjekt (1) ein Magnet (5) zugeordnet ist und wobei Sensor (2) eine mit Wechselstrom beaufschlagte Sensorspule (7) aufweist,
**dadurch gekennzeichnet, dass** in dem Einflussbereich des Sensors (2) eine Folie (4) aus weichmagnetischem Material angeordnet ist, wobei sich die Permeabilität der Folie (4) unter Einfluss eines Magnetfelds in Abhängigkeit der Feldstärke des Magnetfelds ändert und wobei eine Bewegung des Messobjekts (1) im Wesentlichen in Richtungen parallel zu einer Ausdehnungsrichtung der Folie (4) erfolgt, wodurch in der Folie ein Bereich hoher Permeabilität, ein Bereich reduzierter Permeabilität und ein Übergangsbereich zwischen den beiden Bereichen entsteht,
dass in Abhängigkeit des Abstands zwischen Sensor (2) und Messobjekt (1) der Übergangsbereich entlang der Folie (4) verschoben wird und
dass die Änderung der Permeabilität der Folie (4) aus deren Rückwirkung auf den Sensor (2) und daraus die Position und/oder Positionsänderung des Messobjekts (1) relativ zu dem Sensor (2) geschlossen wird.

13. Sensoranordnung nach Anspruch 12, **dadurch gekennzeichnet, dass** die Folie (4) kapazitiv mit der Sensorspule (7) gekoppelt ist und einen elektrischen Kontakt (6) ausweist, wobei
ein Oszillator (14) zwischen dem Kontakt (6) der Folie (4) und einem Anschluss (17) der Sensorspule (7) angeschlossen ist.

14. Sensoranordnung nach Anspruch 13, **dadurch gekennzeichnet, dass** ein zweiter Anschluss (18) der Sensorspule (7) mit einem Verstärker (11) der Auswerteschaltung (10) verbunden ist, wobei ein Signal $U_2$ am Ausgang des Verstärkers (11) proportional zur Impedanzänderung $\Delta Z/Z$ der Sensorspule (7) ist.

15. Sensoranordnung nach einem der Ansprüche 8 bis 14, **dadurch gekennzeichnet, dass** der Sensor (17) auf einen runden Träger (21) aufgebracht ist oder dass der Sensor (34) flächig ausgestaltet und auf einem vorzugsweise planen Träger aufgebracht ist.

16. Sensoranordnung nach einem der Ansprüche 8 bis 15, **dadurch gekennzeichnet, dass** sich bedingt durch die Änderung der Permeabilität der Folie die Eindringtiefe des durch die Sensorspule (7) erzeugten elektromagnetischen Feldes erhöht und dass die Folie (4) derart in ihrer Dicke dimensioniert ist, dass das elektromagnetische Feld in Bereichen mit niedriger Permeabilität durch die Folie (4) hindurchtreten kann und/oder
dass eine leitfähige Fläche vorgesehen ist, die nahe der Folie (4) und auf der der Sensorspule (7) abgewandten Seite angeordnet ist, wobei
das durch die Folie (4) hindurchtretende elektromagnetische Feld in der leitfähigen Fläche Wirbelströme induzieren kann.

17. Verfahren zum Bestimmen der Position und/oder Positionsänderung eines Messobjekts relativ zu einem Sensor (2), wobei die Bewegung des Messobjekts (1) im Wesentlichen in Richtungen parallel zu einer Ausdehnungsrichtung der Folie (4) erfolgt und wobei der Sensor (2) eine mit Wechselstrom beaufschlagte Sensorspule (7) aufweist,
**dadurch gekennzeichnet, dass** durch einen dem Messobjekt (1) zugeordneten Magneten (5) in einer weichmagnetischen Folie (4), deren Permeabilität sich unter Einfluss eines Magnetfelds in Abhängigkeit der Feldstärke des Magnetfelds ändert und die in dem Einflussbereich des Sensors (2) angeordnet ist, eine Änderung der Permeabilität der Folie (4) hervorgerufen wird, wodurch in der Folie ein Bereich hoher Permeabilität, ein Bereich reduzierter Permeabilität und ein Übergangsbereich zwischen den beiden Bereichen entsteht,

dass in Abhängigkeit des Abstands zwischen Sensor (2) und Messobjekt (1) der Übergangsbereich entlang der Folie (4) verschoben wird und

dass die Änderung der Permeabilität der Folie (4) aus deren Rückwirkung auf den Sensor (2) und daraus die Position und/oder Positionsänderung des Messobjekt (1) relativ zu dem Sensor (2) bestimmt wird.

## Claims

1. Method for determining the position and/or change in position of a measurement object relative to a sensor (2), the sensor (2) comprising a sensor coil (7) to which an alternating current is applied, **characterised in that**, as a result of a magnet (5), which is assigned to the measurement object (1), in a soft-magnetic foil (4), the permeability of which foil changes under the influence of a magnetic field depending on the field intensity of the magnetic field and which foil is arranged in the region of influence of the sensor (2), the permeability of the foil (4) is changed, **in that** the change in permeability of the foil (4) is determined from the feedback thereof on the sensor (2) and the position and/or change in position of the measurement object (1) relative to the sensor (2) is determined from said permeability, and **in that** a magnetic field is generated by a compensating coil (8) excited by direct current, by means of which magnetic field the permeability of the foil (4) or parts of the foil (4) is influenced.

2. Method according to claim 1, **characterised in that** the direct current is set such that a substantially constant magnetic field of the sensor coil (7) is set.

3. Method according to either claim 1 or claim 2, **characterised in that** the following steps are carried out in order to calibrate the sensor (2):

   positioning the measurement object (1) in a plurality of positions $h$ relative to the sensor (2) at an increment $\delta h$,
   supplying an alternating current to the sensor coil (7),
   determining the impedance $Z$ and/or relative impedance change $\Delta Z/Z$ of the sensor coil (7) in each of the positions,
   determining a characteristic that describes a dependence of the relative sensitivity $S$ of the sensor coil (7) on the position $h$ of the measurement object (1), where

$$S = \frac{\Delta Z}{Z}\bigg/\delta h$$

   determining a position $h_0$ in the characteristic at which the relative sensitivity $S$ assumes maximum values,
   storing the value of the complex impedance $Z_0$, which corresponds to the position $h_0$, in a non-volatile memory,
   supplying a direct current to the compensating coil (8),
   determining the impedance $Z$ and/or relative impedance change $\Delta Z/Z$ of the sensor coil (7) at each position $h$, the magnetic fields of the sensor coil (7), the compensating coil (8) and the magnet (5) acting on the foil (4),
   changing the direct current in the measurement range $\pm\Delta h$ until a stored target value of the impedance is reached, and
   determining the dependence of the direct current on the change in position of the measurement object (1).

4. Method according to any one of claims 1 to 3, **characterised in that**, in order to detect the feedback on the sensor coil (7) caused by the change in permeability of the foil (4), the impedance or the change thereof is determined.

5. Method according to any one of claims 1 to 4, **characterised in that** the magnitude of the direct current through the compensating coil (8) is adjusted in a tracking control by a closed control loop, it being possible for the ratio $D = \mathrm{Re}\{Z\}/\mathrm{Im}\{Z\}$ from the real part $\mathrm{Re}\{Z\}$ and the imaginary part $\mathrm{Im}\{Z\}$ of the complex impedance $Z$ of the sensor coil (7) to be used as the target value for the control loop.

6. Method according to claim 5, **characterised in that** the imaginary part $\mathrm{Im}\{Z\}$ is used to ascertain the change in position between the measurement object (1) and the sensor (2), D being kept constant, or **in that** the strength of the direct current that flows through the compensating coil (8) is used for position determination.

7. Method according to either claim 5 or claim 6, **characterised in that** a maximum relative sensitivity $S$ of the sensor (2) is kept constant over the entire measurement range or a part thereof by the control.

8. Sensor arrangement for determining the position and/or change in position of a measurement object (1) relative to a sensor (2), a magnet (5) preferably being assigned to the measurement object (1) and the sensor (2) preferably comprising a sensor coil (7) to which alternating current is supplied,

**characterised in that** a foil (4) of soft-magnetic material is arranged in the area of influence of the sensor (2), the permeability of the foil (4) changing under the influence of a magnetic field depending on the field intensity of the magnetic field, and **in that** an evaluation circuit (10) is provided, by means of which the change in permeability of the foil (4) is determined from the feedback thereof on the sensor (2) and by means of which the position and/or change in position of the measurement object (1) relative to the sensor (2) is concluded, and **in that** a compensating coil (8) excited by direct current is provided, by means of which compensating coil the permeability of the foil (4) or part of the foil (4) is influenced.

9. Sensor arrangement according to claim 8, **characterised in that** the foil (4) is capacitively coupled to the sensor coil (7) and comprises an electrical contact (6), it being possible for an oscillator (14) to be connected between the contact (6) of the foil (4) and a connection (17) of the sensor coil (7).

10. Sensor arrangement according to claim 9, **characterised in that** a second connection (18) of the sensor coil (7) is connected to an input of an amplifier (11) of the evaluation circuit (10), a signal $U_2$ emitted by the amplifier (11) being proportional to the relative impedance change $\Delta Z/Z$ of the sensor coil (7).

11. Sensor arrangement according to claim 10, **characterised in that** an electronic arrangement (12) is provided in order to ascertain two orthogonal components of the voltage $U_2$, one of the two components being proportional to the real part Re{$Z$} and the other being proportional to the imaginary part Im{$Z$} of the complex impedance $Z$ of the sensor coil (7), and **in that** the electronic arrangement (12) optionally produces signals $U_3$ and $U_4$, the oscillator (14) synchronising as a result of the signal $U_4$ and the signal $U_3$ being used to control the voltage source (13).

12. Sensor arrangement for determining the position and/or change in position of a measurement object (1) relative to a sensor (2), a magnet (5) being assigned to the measurement object (1) and the sensor (2) comprising a sensor coil (7) to which alternating current is applied, **characterised in that** a foil (4) made of soft-magnetic material is arranged in the region of influence of the sensor (2), the permeability of the foil (4) changing under the influence of a magnetic field depending on the field intensity of the magnetic field and a movement of the measurement object (1) occurring substantially in directions parallel to an expansion direction of the foil (4), as a result of which a region of high permeability, a region of reduced permeability and a transition region between these two regions occur in the foil,

**in that** the transition region is moved along the foil (4) depending on the distance between the sensor (2) and the measurement object (1), and **in that** the change in permeability of the foil (3) is concluded from the feedback thereof on the sensor (2) and the position and/or change in position of the measurement object (1) relative to the sensor (2) is concluded from said permeability.

13. Sensor arrangement according to claim 12, **characterised in that** the foil (4) is capacitively coupled to the sensor coil (7) and comprises an electrical contact (6), an oscillator (14) being connected between the contact (6) of the foil (4) and a connection (17) of the sensor coil (7).

14. Sensor arrangement according to claim 13, **characterised in that** a second connection (18) of the sensor coil (7) is connected to an amplifier (11) of the evaluation circuit (10), a signal $U_2$ at the output of the amplifier (11) being proportional to the impedance change $\Delta Z/Z$ of the sensor coil (7).

15. Sensor arrangement according to any one of claims 8 to 14, **characterised in that** the sensor (17) is attached to a circular support (21), or **in that** the sensor (34) is flat and is attached to a preferably planar support.

16. Sensor arrangement according to any one of claims 8 to 15, **characterised in that**, owing to the change in permeability of the foil, the penetration depth of the electromagnetic field generated by the sensor coil (7) increases and **in that** the foil (4) is of such a thickness that the electromagnetic field can pass through the foil (4) in regions having low permeability, and/or **in that** a conductive surface is provided which is arranged close to the foil (4) and on the side facing away from the sensor coil (7), it being possible for the electromagnetic field passing through the foil (4) to induce eddy currents in the conductive surface.

17. Method for determining the position and/or change in position of a measurement object relative to a sensor (2), the movement of the measurement object (1) being substantially parallel to an expansion direction of the foil (4) and the sensor (2) comprising a sensor coil (7) to which alternating current is applied, **characterised in that**, by means of a magnet (5), which is assigned to the measurement object (1), in a soft-magnetic foil (4), the permeability of which foil changes under the influence of a magnetic field depending on the field intensity of the magnetic field and which foil is arranged in the region of influence of the sensor (2), the permeability of the foil (4) is changed, a region of high permeability, a region of reduced permeability and a transition region between these two regions occurring in the foil,

**in that** the transition region is moved along the foil (4) depending on the distance between the sensor (2) and the measurement object (1) and

**in that** the change in permeability of the foil (4) is determined from the feedback thereof on the sensor (2) and the position and/or change in position of the measurement object (1) relative to the sensor (2) is determined from said permeability.

## Revendications

1. Procédé de détermination de la position et/ou de la modification de la position d'un objet mesuré par rapport à un détecteur (2), le détecteur (2) présentant une bobine de détecteur (7) alimentée en courant alternatif,
**caractérisé en ce qu'**un aimant (5) affecté à l'objet mesuré (1), placé dans un film (4) magnétique doux dont la perméabilité varie sous l'influence d'un champ magnétique en fonction de l'intensité de champ du champ magnétique et qui est disposé dans la zone d'influence du détecteur (2), suscite une variation de la perméabilité du film (4), **en ce que** la variation de la perméabilité du film (4) est définie à partir de sa rétroaction sur le détecteur (2), ce qui permet de définir la position et/ou la modification de la position de l'objet mesuré (1) par rapport au détecteur (2), et **en ce qu'**une bobine de compensation (8) excitée par un courant continu produit un champ magnétique au moyen duquel la perméabilité du film (4) ou de parties du film (4) est influencée.

2. Procédé selon la revendication 1, **caractérisé en ce que** le courant continu est réglé de telle sorte qu'un champ magnétique essentiellement constant de la bobine de détecteur (7) est obtenu.

3. Procédé selon la revendication 1 ou 2, **caractérisé en ce que** les étapes suivantes sont effectuées pour l'étalonnage du détecteur (2) :

   positionnement de l'objet mesuré (1) dans une multiplicité de positions h par rapport au détecteur (2) avec un incrément $\delta h$,
   injection d'un courant alternatif dans la bobine de détecteur (7),
   définition de l'impédance $Z$ et/ou de la variation d'impédance relative $\Delta Z/Z$ de la bobine de détecteur (7) dans chacune des positions,
   définition d'une courbe caractéristique qui décrit une dépendance de la sensibilité relative $S$ de la bobine de détecteur (7) vis-à-vis de la position $h$ de l'objet mesuré (1), où

$$S = \frac{\Delta Z}{Z} \Big/ \delta h$$

   définition d'une position $h_0$ dans la courbe caractéristique, pour laquelle la sensibilité relative $S$ adopte des valeurs maximales,
   enregistrement dans une mémoire non volatile de la valeur de l'impédance complexe $Z_0$ qui correspond à la position $h_0$,
   injection d'un courant continu dans la bobine de compensation (8),
   définition de l'impédance $Z$ et/ou de la variation d'impédance relative $\Delta Z/Z$ de la bobine de détecteur (7) dans chaque position $h$, les champs magnétiques de la bobine de détecteur (7), de la bobine de compensation (8) et de l'aimant (5) agissant sur le film (4),
   modification du courant continu dans la plage de mesure $\pm \Delta h$ jusqu'à l'obtention d'une valeur de consigne enregistrée de l'impédance,
   détermination de la dépendance du courant continu vis-à-vis de la modification de position de l'objet mesuré (1).

4. Procédé selon l'une des revendications 1 à 3, **caractérisé en ce que**, pour la détection de la rétroaction suscitée sur la bobine de détecteur (7) par la variation de la perméabilité du film (4), une définition de l'impédance ou respectivement de sa modification est effectuée.

5. Procédé selon l'une des revendications 1 à 4, **caractérisé en ce que** la grandeur du courant continu à travers la bobine de compensation (8) est réglée dans une commande d'asservissement par un circuit de régulation fermé,
le quotient $D = \text{Re}\{Z\}/\text{Im}\{Z\}$ *issu* de la partie réelle **Re**{*Z*} et de la partie imaginaire **IM**{*Z*} de l'impédance complexe $Z$ de la bobine de détecteur (7) pouvant être utilisé en tant que valeur de consigne pour le circuit de régulation.

6. Procédé selon la revendication 5, **caractérisé en ce que** la partie imaginaire **Im**{*Z*} est utilisée pour la détermination de la modification de position entre l'objet mesuré (1) et le détecteur (2), D étant maintenu constant, ou **en ce que** l'intensité du courant continu qui traverse la bobine de compensation (8) est utilisée pour la définition de la position.

7. Procédé selon la revendication 5 ou 6, **caractérisé en ce que** la régulation maintient constante une sensibilité relative maximale $S$ du détecteur (2) sur toute la plage de mesure ou sur une partie de celle-ci.

8. Dispositif de détecteur pour la définition de la position et/ou de la modification de la position d'un objet mesuré (1) par rapport à un détecteur (2), un aimant (5) étant de préférence affecté à l'objet mesuré (1), et le détecteur (2) présentant de préférence une bobine de détecteur (7) alimentée en courant alternatif, **caractérisé en ce qu'**un film (4) en matériau magnétique doux est disposé dans la zone d'influence du détecteur (2), la perméabilité du film (4) variant sous l'influence d'un champ magnétique en fonction de l'intensité de champ du champ magnétique, et **en ce qu'**il est prévu un circuit d'analyse (10) au moyen duquel la variation de la perméabilité du film (4) est définie à partir de sa rétroaction sur le détecteur (2), et la position et/ou la modification de la position de l'objet mesuré (1) par rapport au détecteur (2) est déduite, et **en ce qu'**il est prévu une bobine de compensation (8) excitée avec du courant continu avec laquelle la perméabilité du film (4) ou d'une partie du film (4) est influencée.

9. Dispositif de détecteur selon la revendication 8, **caractérisé en ce que** le film (4) est couplé par voie capacitive à la bobine de détecteur (7) et présente un contact (6) électrique, un oscillateur (14) peut être connecté entre le contact (6) du film (4) et une connexion (17) de la bobine de détecteur (7).

10. Dispositif de détecteur selon la revendication 9, **caractérisé en ce qu'**une deuxième connexion (18) de la bobine de détecteur (7) est raccordée à une entrée d'un amplificateur (11) du circuit d'analyse (10), un signal $U_2$ délivré par l'amplificateur (11) étant proportionnel à la variation d'impédance relative $\Delta Z/Z$ de la bobine de détecteur (7).

11. Dispositif de détecteur selon la revendication 10, **caractérisé en ce qu'**il est prévu un dispositif électronique (12) pour la détermination de deux composantes orthogonales de la tension $U_2$, une des deux composantes étant proportionnelle à la partie réelle **Re{Z},** et l' autre composante étant proportionnelle à la partie imaginaire **Im{Z}** de l'impédance complexe $Z$ de la bobine de détecteur (7), et **en ce que** le dispositif électronique (12) produit éventuellement des signaux $U_3$ et $U_4$, l'oscillateur (14) étant synchronisé par le signal $U_4$, et le signal $U_3$ étant utilisé pour la commande de la source de tension (13).

12. Dispositif de détecteur pour la définition de la position et/ou de la modification de la position d'un objet mesuré (1) par rapport à un détecteur (2), un aimant (5) étant affecté à l'objet mesuré (1), et le détecteur (2) présentant une bobine de détecteur (7) alimentée en courant alternatif, **caractérisé en ce que**, dans la zone d'influence du détecteur (2), il est disposé un film (4) en matériau magnétique doux, la perméabilité du film (4) variant sous l'influence d'un champ magnétique en fonction de l'intensité de champ du champ magnétique, et un mouvement de l'objet mesuré (1) s'effectuant essentiellement dans des directions parallèles à une direction d'extension du film (4), ce qui produit dans le film une zone de perméabilité élevée, une zone de perméabilité réduite et une zone de transition entre les deux zones, **en ce que** la zone de transition est déplacée le long du film (4) en fonction de la distance entre le détecteur (2) et l'objet mesuré (1), et **en ce que** la variation de la perméabilité du film (4) est déduite à partir de sa rétroaction sur le détecteur (2) et, à partir de là, la position et/ou la modification de la position de l'objet mesuré (1) par rapport au détecteur (2) est déduite.

13. Dispositif de détecteur selon la revendication 12, **caractérisé en ce que** le film (4) est couplé par voie capacitive à la bobine de détecteur (7) et présente un contact (6) électrique, un oscillateur (14) étant connecté entre le contact (6) du film (4) et une connexion (17) de la bobine de détecteur (7).

14. Dispositif de détecteur selon la revendication 13, **caractérisé en ce qu'**une deuxième connexion (18) de la bobine de détecteur (7) est raccordée à un amplificateur (11) du circuit d'analyse (10), un signal $U_2$ à la sortie de l'amplificateur (11) étant proportionnel à la variation d'impédance $\Delta Z/Z$ de la bobine de détecteur (7).

15. Dispositif de détecteur selon l'une des revendications 8 à 14, **caractérisé en ce que** le détecteur (17) est mis en place sur un support (21) rond ou **en ce que** le détecteur (34) est constitué à plat et est mis en place sur un support de préférence plan.

16. Dispositif de détecteur selon l'une des revendications 8 à 15, **caractérisé en ce que**, du fait de la variation de la perméabilité du film, la profondeur de pénétration du champ électromagnétique produit par la bobine de détecteur (7) augmente, et **en ce que** le film (4) est dimensionné quant à son épaisseur de telle sorte que le champ électromagnétique peut traverser le film (4) dans des zones de faible perméabilité, et/ou **en ce qu'**il est prévu une surface conductrice qui est disposée près du film (4) et sur le côté éloigné de la bobine de détecteur (7), le champ électromagnétique traversant le film (4) pouvant induire des courants de Foucault dans la surface conductrice.

17. Procédé de définition de la position et/ou de la modification de la position d'un objet mesuré par rapport à un détecteur (2), le mouvement de l'objet mesuré (1) s'effectuant essentiellement dans des directions parallèles à une direction d'extension du film (4), et le détecteur (2) présentant une bobine de détecteur (7) alimentée en courant alternatif, **caractérisé en ce qu'**un aimant (5), affecté à l'objet mesuré (1) et placé dans un film (4) magnétique doux dont la perméabilité varie sous l'influence d'un champ magnétique en fonction de l'intensité de champ du champ magnétique et qui est disposé dans la zone d'influence du détecteur (2), suscite une variation de la perméabilité du film (4), ce qui produit dans le film une zone de perméabilité élevée, une zone de perméabilité réduite et une zone de transition entre les deux zones,

**en ce que** la zone de transition est déplacée le long du film (4) en fonction de la distance entre le détecteur (2) et l'objet mesuré (1), et

**en ce que** la variation de la perméabilité du film (4) est définie à partir de sa rétroaction sur le détecteur (2) et, à partir de là, la position et/ou la modification de la position de l'objet mesuré (1) par rapport au détecteur (2) est définie.

Fig. 1

Fig. 2

Fig. 3

Fig. 4

EP 2 137 499 B1

Fig. 5

22

Fig. 6

(A)

3

4

D

7

8

6

5

h

2

(B)

6

8

7

4

h

2

(C)

26

8

7 6

25

4

Δh

Fig. 7

Fig. 8

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 3610479 A1
- EP 1158266 A1
- DE 20307652 U1
- US 4926122 A
- EP 0729589 B1
- DE 3041041 C2
- DE 3803293 A1
- DE 3803253 A1
- US 20020163328 A1
- US 6605939 B1